# EUROPEAN PATENT SPECIFICATION

(11) **EP 2 104 123 B1**
(45) Date of publication and mention of the grant of the patent: **16.05.2012**
(21) Application number: 08102852.4
(22) Date of filing: 21.03.2008
(51) Int. Cl.: H01G 9/20, H01L 51/00

(54) **Method of manufacturing a dye-sensitised solar cell and dye-sensitised solar cell**
Verfahren zur Herstellung einer farbstoffsensibilisierten Solarzelle und farbstoffsensibilisierte Solarzelle
Procédé de fabrication d'une cellule solaire sensibilisée aux colorants et cellule solaire sensibilisée aux colorants

(43) Date of publication of application: 23.09.2009
(73) Proprietor: Tata Steel Nederland Technology B.V., 1970 CA IJmuiden (NL)
(72) Inventor: Van Krevel, Joost Willem Hendrik, 1942 LH Beverwijk (NL)
(74) Representative: Kruit, Jan

(56) References cited:
- US-A1- 2005 067 007
- US-A1- 2006 180 193
- US-A1- 2007 201 187
- SURYANARAYANAN V ET AL: "Porosity of core-shell nanoparticles" J. MATER. CHEM.; JOURNAL OF MATERIALS CHEMISTRY SEP 7 2004, vol. 14, no. 17, 7 September 2004 (2004-09-07), pages 2661-2666, XP007905011

## Description

### Field of the invention

The invention relates to a method of manufacturing a dye-sensitised solar cell and a dye-sensitised solar cell comprising a photo-active layer. A dye-sensitised solar cell is a type of a photovoltaic device for conversion of light into electricity, wherein the light absorbing material comprises a spectrally photosensitive dye generally comprised in a porous carrier.

### Background of the invention

Owing to demands imposed on future energy requirements coupled with desire for environmentally friendly energy, photovoltaic power generation systems have gained momentum in recent decades and are now being commercially exploited and are growing in prevalence. While the traditional solar cell or photovoltaic device market has advocated cells based on p-n junction silicon wafer-based solar cells which are characterised by high manufacturing costs, recent research efforts are focussed on providing low cost manufacturing processes to provide inexpensive solar cells for photovoltaic power generation systems. A potentially interesting example concerns dye-sensitised solar cells.

The prototype of a dye-sensitised solar cell was a photoelectric conversion element first reported in 1991 by Graezel, et al. of Ecole Polytechnique Federale de Lausanne (M. Graezel, Nature, 353, 737 (1991)). This was generally called a dye-sensitised solar cell, a wet-type solar cell, or a Graezel-type solar cell. Significant features of this type of photoelectric conversion element are that it may have a photoelectric conversion efficiency as high as that of amorphous silicon-type solar cells and that its production cost can be low, depending on the selection of materials, manufacturing processes and applications.

US2005/0067007 A1 relates to a manufacturing process for the continuous production of flexible photovoltaic elements and to the mass production of flexible solar cells, such as Graezel cells.

Dye-sensitised solar cells have a transparent front electrode composed of a conductor such as transparent conductive metals or metal oxides that most often is carried by a transparent substrate. An example thereof is a glass substrate provided with a transparent conductive oxide (TCO) film such as fluorine-doped tin oxide (FTO) or indium tin oxide (ITO) on the substrate surface facing the photo-active layer(s) to be described below. On the conductor a semiconductor film having a porous structure is applied. The porous semiconductor film e.g. comprising a semi conductive metal oxide, has pores in which a spectrally photosensitive dye is adsorbed. This assembly is also known as a dye-sensitised semiconductor electrode. A back electrode (or counter electrode) is disposed spaced apart from the metal oxide semiconductor film leaving free a gap or space. This gap between the dye-sensitised semiconductor electrode and the counter electrode is filled with a suitable electrolyte. The gap is hermetically sealed to prevent leakage of the electrolyte using sealants.

Thus, a typical dye-sensitised solar cell comprises three parts, i.e., a dye-sensitised semiconductor electrode, an electrolytic layer, and a back electrode. The dye-sensitised semiconductor electrode may have a sheet-shaped structure, for example, composed of a substrate and an electroconducting layer having formed thereon a porous metal oxide film having a sensitizing dye adsorbed in the pores and/or on the external surface.

Typically, the back electrode may also have a sheet-shaped structure composed of a substrate having an electroconducting film and a catalyst layer. Here, the catalyst plays a role of promoting the reduction reaction of electrolyte in the electrolytic solution when the cell is in service. Generally, platinum, carbon black or graphite is used as the catalyst.

The electrolytic layer, which is generally composed of a solution or gel of an electrolyte, is placed in between the dye-sensitised semiconductor electrode and the back electrode so as to be in electrochemical contact with both of the electrodes.

In such a solar cell, irradiation of light through the transparent front electrode allows the generation of charge carriers such as electrons in the dye by light absorption and subsequent migration of the generated electrons through the porous structure of the semiconductor to the conductor on the side of the front electrode and then to the outer circuitry. The electrolyte (a redox couple) passes electrons from the outer circuitry to the dye, where they are recombined with a dye in order to reconstitute the dye that can be sensitised again.

It can be inferred from the mechanism of photoelectric conversion, that the photoelectric conversion efficiency of a dye-sensitised solar cell largely depends on the performance of the dye-sensitised semiconductor electrode. To increase the photoelectric conversion efficiency of a dye-sensitised solar cell, the porous structure and composition of the semiconductor film are particularly important. Specifically, for a dye-sensitised solar cell to act stably, it is necessary to keep fine particles of the semi conductive material such as metal oxide in a state of contact with each other. This is because contact of metal oxide fine particles with each other allows photo-induced charge-separated electrons in the sensitizing dye to flow efficiently to and through the metal oxide.

The type of fine particles and degree of adhesion between the fine particles is also assumed to influence the electron conductivity. Nevertheless, it is effective to make the semiconductor film porous, because the porous film leads to an increase in area per unit volume of the film, so that the adsorbed amount of sensitizing dye can be increased. The preference is to have a high specific surface (m²/m³), therefore a high load of pigment (dye) and therefore more light absorption and contact with the electrolyte.

A technique has been reported for performing sintering of a metal oxide at a low temperature using a flexible polymer as a substrate of the sheet-shaped electrode (for example, B. A. Gregg et al., Langmuir, 2000, Vol. 16, 5626). In this case, a polymer, which is more transparent and further endurable to corrosion by the electrolyte than a metal foil, can be used as a substrate of the sheet-shaped dye electrode and hence, a dye-sensitised solar cell which takes advantage of the feature of a polymer substrate and has high performance would be anticipated.

In the case where sintering is performed at low temperatures, the type of metal oxide used also influences the performance of the solar cell. For example, titanium oxide produced by hydrolysis of a metal alkoxide and supplied in the form of a solvent dispersion, is not suitable in the case where sintering is performed at low temperatures. This is because organic substances used in the production process are adsorbed and remain on the surface of such metal oxide fine particles, which deteriorates the electrical interconnection between the fine particles and the dye, so that migration of electrons is blocked, resulting in poor performance.

When the porous semiconductor film is sintered at high temperatures starting from fine particles, this problem does not occur. This is presumably because the adsorbed organic substances are removed from the surface of the metal oxide fine particles by heating at temperatures of greater than 400 degrees Celsius, resulting in electrical contact between the fine particles (for example, K. Murakoshi et al., J. Electroanal. Chem., 1995, Vol. 396, 26).

More recently, it has been suggested to use metal strips as a support, upon which subsequent manufacturing of a solar cell takes place. For example, a continuous production method of solar cell panels has been suggested on steel strip by roll-to-roll processing. For the manufacturing of dye-sensitised solar cells using roll-to-roll processing, it is important to perform the sintering of the semiconductor layer, such as a titania layer, within a short time, e.g. within a minute.

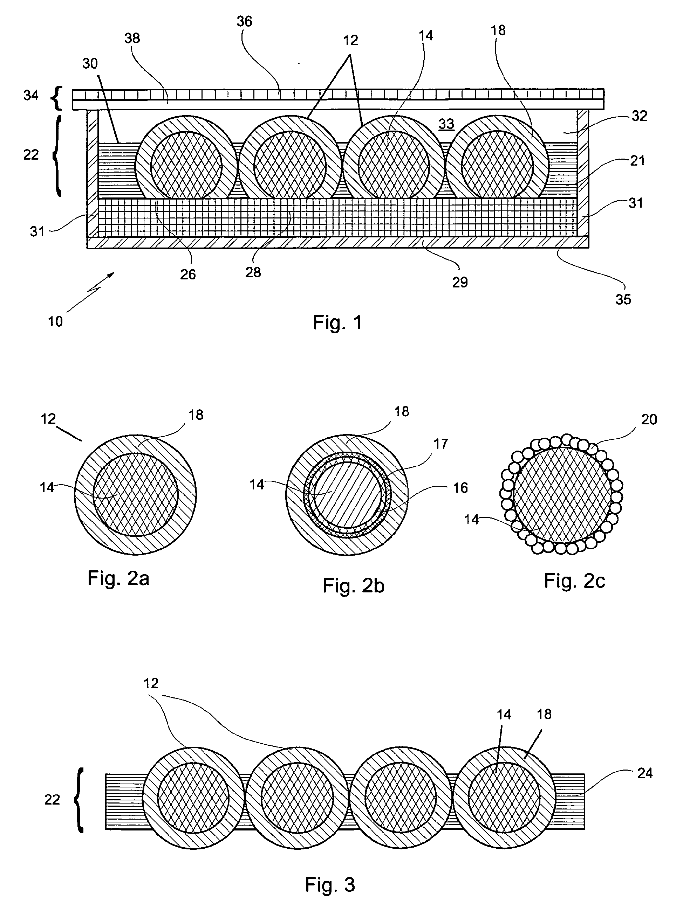

US2007/0201187 A1 discloses a method of manufacturing a dye-sensitised solar cell. As illustrated by FIG.1, a metal oxide layer of several microns thickness is deposited onto a first transparent conductive oxide (TCO) electrode layer. Following deposition, the paste is dried to remove the solvent and then sintered at temperatures up to 450°C. After drying and cooling, the porous metal oxide layer is coated with a sensitiser dye by immersion in a low concentration (≤ 1 mM) dye solution for an extended period, typically 24 hours, to allow absorption of the sensitiser dye onto the metal oxide layer. The first TCO electrode layer, having the porous metal oxide layer and dye layer formed thereon, is then assembled with a second TCO electrode layer. Both electrode layers are sandwiched together with a perimeter spacer dielectric encapsulant to create an electrode-to-electrode gap of at least 10 µm, before filling with an electrolyte layer.

US2006/0180193 A1 relates to the manufacture of a dye-sensitised solar cell comprising a photoacceptive layer comprising a metal oxide of a core-shell structure, which comprises the steps of coating TiO₂ paste on a transparent conductive glass substrate coated with ITO; subjecting the coated glass substrate to a thermal treatment process at 450°C; forming a protective (shell) layer on the thermally treated sample and immersing the resultant photoelectrode in a dye for 20 hours to allow the dye to be absorbed to the photoelectrode. A transparent conductive glass electrode coated with Pt is then disposed so as to face the dye-absorbed photoelectrode as a counter electrode, thereby forming the cell.

T. Pradeep et al. investigated the porosity titania and zirconia covered Ag and Au nanoparticles using the metal core reactivity as probe (J. MATER. CHEM; 2004-09-07). Although titania sintering seems possible to be performed rapidly, the absorption of the dye by a porous sintered titanium oxide layer may typically take up to 16 hours, which is a considerable impediment to a (roll-to-roll) continuous process. To manufacture a dye-sensitised solar cell continuously, it is important that certain time-consuming manufacturing process steps can be considerably altered to speed-up processing of the device.

Therefore, it is an object of the invention to provide for a method of manufacturing a dye-sensitised solar cell in which there are quicker processing steps, thereby allowing dye-sensitised solar cells to be produced continuously. A further object of the invention is to provide a design of a dye-sensitised solar cell which allows for production in a continuous way.

In a first aspect of the invention there is provided a method of manufacturing a dye-sensitised solar cell, comprising the steps of:
providing a back electrode,
providing a transparent front electrode for receiving light;
arranging a photo-active layer comprising a matrix of a non-conductive material and discrete elements, wherein a discrete element comprises a porous structure of a semi conductive material at least over part of its outer surface, in which structure a light sensitive dye is present, the discrete elements being partially exposed on both main surfaces of the photo-active layer, between the transparent front electrode and the back electrode leaving free a gap between the photo-active layer and the transparent front electrode; and
adding an electrolyte in the gap between the photo-active layer and the front electrode,
such that the discrete elements of the photo-active layer are in electrical contact with the back electrode and with the electrolyte.

In the method according to the invention the photo-active layer comprising the discrete elements having a porous structure at least over part of its outer surface in a non-conductive matrix is a semi finished article. This semi finished article is prepared separately. Thereby the lengthy adsorption step required for filling the pores of the outer porous structure of the discrete elements does not affect the process time of the method according to the invention. Furthermore the elements are arranged, e.g. embedded in a non-conductive matrix, such as a plastic foil, preferably a silicone film. The matrix acts as a common support or carrier for the elements allowing easy handling and positioning thereof with respect to the other components. The matrix is impermeable to the electrolyte. In the finished dye-sensitised solar cell made according to the invention, this matrix also serves as a barrier between the electrolyte and the back electrode. The conversion of light by generating charge carriers occurs in the dye that is present in the outer porous structure of semi conductive material. Such a photo-active layer may be supplied from a stock roll, which is easy to use in a continuous manufacturing process of (metal) supported solar sensitised solar cells.

Parts of the discrete elements are exposed at both main surfaces of the photo-active layer, such that the porous structure comprising dye of these elements contact the electrolyte at the photo-active layer's first main surface facing the front electrode on the one hand. On the other hand the elements contact the back electrode at the second main surface opposite the first main surface. The front electrode is spaced apart from the first surface of the photo-active layer leaving free a gap or space. This gap is filled with the electrolyte.

In a preferred embodiment, the matrix comprises an insulating foil wherein the elements are embedded such that on both main surfaces of the foil the elements are partially exposed. This means that at least one dimension of the elements, e.g. the diameter in case of spherical particles, is larger than the foil thickness.

Because of a large contact area, preferably the elements project from a first main surface of the photo-active layer such that the elements partially extend into the electrolytic layer. In view of manufacturing and mechanical stability advantageously the second main surface of the photo-active layer facing the back electrode is flat.

As explained above, due to the use of the photo-active layer prepared in advance, the method according the invention is particularly suitable to be carried out as a continuous process, because the other components can be applied by processes that do not require a long time. Continuous production offers lower manufacturing costs. A preferred example of a continuous process is a roll-to-roll process, wherein the back electrode is applied e.g. coated to a support that is wound from a stock roll. A preferred example of such a support is a steel substrate. After processing, the finished support can be wound on a roll again. Alternatively, the support itself can be the back electrode. Advantageously, the electrodes, especially the back electrode is applied as a layer, e.g. by a coating process.

In the dye-sensitised solar cell according to the invention the photo-active layer comprises a number of discrete elements. Such an element has a porous outer structure of a semi conductive material. At least the pores thereof are filled with the light sensitive dye, e.g. by immersion or injection. The porous outer structure has several functions in the invention. It acts as a support providing a high specific area (m²/m³) for the dye. The semi conductive material also transmits the electrons generated by received light from the dye towards the back electrode. Furthermore the porous structure acts as a scattering means for scattering light not directly absorbed by the dye, thereby increasing the overall efficiency of the solar cell.

Here it is noted that WO-A1-2005/043632 has disclosed a multilayered photovoltaic device on an envelope surface, wherein all the layers necessary for making a photovoltaic cell are present on each envelope. In a preferred embodiment these layers are within a hollow (hemi)spherical structure, which is made from a transparent material.

A discrete element may have any shape, like granules, powder and beads. In view of designing and processing a regular shape of the elements is preferred, e.g. a polygonal cross-section. More preferably, an element having a circular cross-section, such as a spherical particle or round wire is present. Small spherical or cylindrical elements (e.g. 10 < diameter < 300 micron) can be prepared by coating a solid core particle with a suitable metal oxide fine powder, preferably titanium oxide, and then subjecting the thus coated particles to high temperature sintering while the coated particles are in motion e.g. in a moving bed reactor, to prevent aggregation and agglomeration. In a further preferred embodiment the discrete elements have a flat or flattened bottom side that is not covered with the outer porous structure

In yet another preferred embodiment an element has a core or central portion acting as a support for the porous structure.

Advantageously the core is made from a conductive metal, preferably a corrosion resistant metal, which is also inert with respect to the dye and electrolyte. A preferred example thereof is titanium.

In an alternative advantageous embodiment of the invention the core is made from an insulating material, preferably glass. Dependent on the nature of the glass and the absorbing material it may be required to interpose a diffusion barrier layer between the glass core and the porous layer. For example, when a fluorine doped tin oxide (SnO₂:F) light sensitive dye is used, diffusion of sodium (ions) from the glass core should be prevented by a diffusion barrier layer e.g. made of SiO₂, Si(O,C,N) etc.. Otherwise the action of the dye would be impaired.

Preferably, the semi conductive material of the porous structure itself comprises titanium oxide, preferably titanium oxide (titania) of the anatase type.

The solar cell according to the invention may comprise an encapsulation holding the device together. Preferably, the device is supported on a metal support, e.g. a steel support, that already may have been coated. In a continuous process a panel comprising a plurality of solar cells as described above can be manufactured.

In a further aspect of the invention, there is provided a dye-sensitised solar cell for conversion of light into electricity comprising:
a transparent front electrode for receiving light;
a photo-active layer spaced apart from the transparent front electrode, the photo-active layer comprising a matrix of a non-conductive material and discrete elements, wherein a discrete element comprises a porous structure of a semi conductive material at least over part of its outer surface, in which structure a light sensitive dye is present, the discrete elements being partially exposed on both main surfaces of the photo-active layer; and
an electrolyte in electrical contact with the transparent front electrode and the discrete elements at a first main surface of the photo-active layer; and
a back electrode in electrical contact with the discrete element at a second main surface of the photo-active layer.

This design of a dye-sensitised cell employing a pre-made photo-active layer allows for a relatively quick, preferably continuous manufacturing process having the advantages explained above.

In a third aspect of the invention, there is provided a photo-active layer comprising a matrix of a non-conductive material and discrete elements, wherein a discrete element comprises a porous structure of a semi conductive material at least over part of its outer surface, in which structure a light sensitive dye is present, the discrete elements being exposed on both main surfaces of the photo-active layer, in particular for use in the method according to the invention as described above.

The various advantageous and/or preferred embodiments of the invention as described above with respect to the method according to the invention are applicable to these further aspects of the invention.

Embodiments of the present invention will now be described, by way of example only, with reference to the accompanying drawings in which:
figure 1 shows an embodiment of a dye-sensitised solar cell in accordance with the invention;
figure 2a shows an embodiment of a discrete element used in the photo-active layer according to the invention;
figure 2b shows another embodiments of such a discrete element;
figure 2c shows the porous nature of the outer semiconductor layer of a discrete element;
figure 3 shows an embodiment of a photo-active layer according to the invention;
figure 4 shows a further processed photo-active layer of fig. 3;
figure 5 shows the foil of figure 4 applied to a counter electrode; and
figure 6 diagrammatically shows an embodiment of a continuous manufacturing process according to the invention.

Figure 1 shows an embodiment, in accordance with the invention, of a dye-sensitised solar cell 10 containing inter alia discrete elements, generally indicated by reference numeral 12, in the form of substantially spherical particles.

As shown in figure 2a, the elements 12 may have a core 14 of a conducting material, such as a metal like titanium. Alternatively, as shown in figure 2b, the elements may have a core 14 of an insulating material, such as glass or plastic, optionally provided with a diffusion barrier layer 16 and conductive layer 17 as described below. In addition, an element 12 comprises a porous outer semi conductive layer 18. The porous nature of the outer layer 18 is illustrated in figure 2c. This figure shows that the outer layer 18 is comprised of sintered (nano)particles 20 of e.g. titanium oxide. The porous structure obtained by sintering is filled with a suitable light sensitive dye. The dye may be applied by immersion, injection, coating, spraying and the like.

Returning to figure 1, a photo-active layer 22 comprises an array of discrete elements 12, in the embodiment shown conducting spheres according to figure 2a, which are embedded in an insulating foil 24, made e.g. from a polymer. The bottom surface 26 - one of the main surfaces - of the foil 24 is flattened by polishing or etching so as to remove part of the dye-sensitised semi conductive porous layer 18 to expose the conductive core 14 at various locations in the bottom surface 26. The back electrode 28 is applied such that it contacts the substantially flat bottom portions of the element cores 14 and the adjacent flat portions of porous layer 18. At a predetermined distance above the unpolished upper surface 30 - the other main surface - of the photo-active layer 22 a transparent front electrode 34 comprising a glass substrate 36 internally provided with a layer 38 of a transparent conducting oxide (e.g. indium tin oxide ITO or fluorine doped tin oxide SnO₂:F) is arranged defining a space 33, which is filled with a suitable electrolyte 32. The electrolyte 32 may be solid, gel-like or liquid, or made from a mixture of organics. A tray-like support comprising a bottom part 29 and upstanding side walls 31 is indicated by reference numeral 35.

Referring to the solar cell 10 shown in figure 1, ambient light passes through the front electrode 34 into the electrolyte 32 and impacts the dye-sensitised porous semi conductive layer 18 where the light is absorbed by the dye present in the pores. This results in the dye becoming in an excited state generating charge carriers such as electrons. Then electron transfer occurs from the dye to the material of the porous supporting layer 18 on the spherical cores 14 from where the electrons pass to the back electrode 28, resulting in the generation of electricity. The function of the dye is to absorb in-coming light, while the porous coating 18 facilitates scattering of the light. Current flows in response to light radiation incident on the elements 12 through the electrodes 28, 34.

For the manufacturing of dye sensitised solar cells, it is important to perform the sintering of metal oxide e.g. titanium oxide (sintering powder) to obtain the porous layer 18 within a short time, e.g. less than a minute. Although rapid sintering of titanium oxide is possible, the subsequent adsorption of the dye onto porous titanium oxide normally takes up to 16 hours. To manufacture the solar cells continuously, it is important that such time consuming manufacturing steps can be undertaken off-line or be reduced to less than a minute.

In accordance with this invention, the first step of the off-line manufacturing stage of a photo-active layer 22 includes the preparation of discrete elements 12, preferably comprising small electrically conductive, substantially spherical beads, particles or spheres as cores 14 (see figure 2a), which typically range in size from 40 to 300 micrometers in diameter. Alternatively, the elements in the arrangement shown may be in the form of wire pieces. In this embodiment, advantageously these fine cores 14 should be uniformly shaped and comprise metal, such as titanium. Preferably the cores 14 of the elements 12 are made in accordance with the embodiment of figure 2b from an insulating material such as glass or other inorganic materials. In the case of such glass cores 14, preferably the cores 14 are provided with a diffusion barrier coating 16, an intermediate conductive layer 17 and a porous outer layer 18, prior to their immersion into a dye-containing solution.

The diffusion barrier coating 16 prevents the migration of sodium from the glass cores 14 to the material of its subsequent layer 17. E.g. if SnO₂:F is used as conductive material for this layer 17, the glass cores 14 should be coated with a diffusion barrier layer 16 to prevent sodium (Na) in the glass beads from flowing into SnO₂:F which impairs the conductivity of the SnO₂:F layer 17. The barrier coatings 16 for glass cores 14 may be made from materials such as SiO₂ or amorphous Si(O,C,N), and can be deposited using techniques such as physical vapour deposition (PVD), sol-gel processing or Chemical Vapour Deposition (CVD). A barrier layer having a thickness in the range from 50 nanometres to 1 micron is considered sufficient to prevent the migration of sodium atoms in the process temperature range of manufacturing a solar cell comprising glass spheres.

The conducting layer 17 on the glass beads may comprise transparent conducting oxides such as ITO or SnO₂:F, since these two materials can resist the heat treatment temperatures in the range of 450-550 °C used for sintering to obtain a porous outer layer in further processing steps.

In a following step, the cores 14 having barrier layer 16 and conductive layer 17 are provided with a thin porous layer 18 of material such as porous titanium dioxide e.g. obtained by sintering. The porous structure of layer 18 may be composed of porous nanoparticles. Anatase type titanium oxide is a preferred material for the layer 18.

The porous titanium oxide layer 18 can also be deposited using techniques such as physical vapour deposition (PVD), sol-gel processing or Combustion Chemical Vapour Deposition (CCVD). Preferably the coating thickness is in the range 2-30 microns, but preferably in the range 5-15 microns. In a further step, the elements 12 comprising outer porous layer 18 are immersed into a dye-containing solution, as a result elements 12 having a dye sensitised porous surface layer 18 are obtained. A variety of dye compositions are available such as metallorganic compounds.

The preparation of the photo-active layer comprising the sintering of the oxide at high temperature and adsorption of the dye are off-line processes in the manufacture of the solar cell of the invention described herein. Off-line processing reduces overall manufacturing time of the device and reduces overall costs.

Referring to figure 3, in an off-line step in the manufacture of the solar cell in accordance with this invention, the elements 12 thus prepared are embedded in a flexible non-conductive foil 24 having a thickness smaller than at least one dimension of the elements 12, such as between 30 to 150 microns. Preferably the foil 24 is made with a single layer or array of elements 12 as shown in this figure 3. In this embodiment the elements 12 have a diameter of about 150 microns. The foil 24 may be made from a variety of insulating polymers including but not limited to silicone, polyurethane or epoxy.

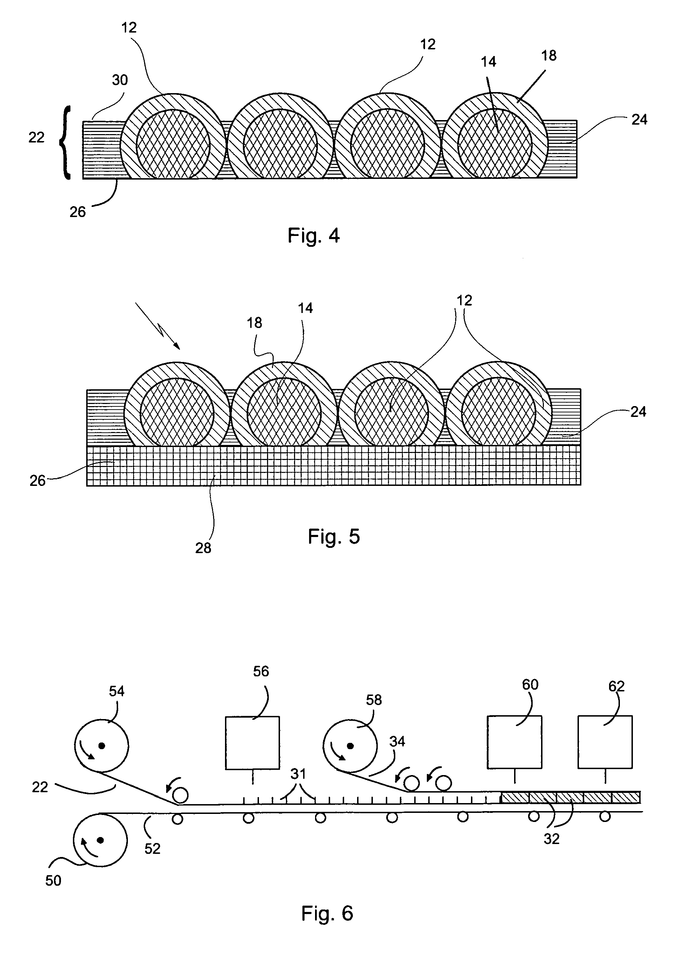

Referring to figure 4, in order to use the foil 24 in the solar cell application in accordance with this invention, one main surface 26 of the foil 24 is polished to remove at least part of the porous layer 18 so that each core 14 is partially exposed at the flattened bottom surface 26 of the foil 24.

In an embodiment the foil 24 can be brought into contact with a back electrode 28. The contact of the polished surface 26 of foil 24 with the back electrode 28 is shown schematically in figure 5. In contrast, the upper surface 30 of the foil 24 is not polished but has dye-sensitised elements 12 partially protruding from it.

At this stage the photo-active layer or the assembly of photo-active layer and back electrode is introduced into the manufacturing line. Then the front electrode 32 having the transparent oxide layer 36 is applied facing the upper surface 30 of the photo-active layer having elements 12 protruding from it, as shown in figure 1. After introducing the electrolyte 32, the upper surface 30 of the photo-active layer 22 having the protruding elements 12 is in direct contact with an electrolyte layer 32 of figure 1, as described above.

The preferred embodiments described herein before with respect to the solar cell according to the invention are similarly applicable to the coated metal support upon which the solar cell may be manufactured.

Preferably the (coated) metal support for the solar cell may comprise a metallic strip material, preferably made of steel. A strip of this kind can be easily manufactured in a roll-to-roll process. This offers a cost advantage over the piece-by-piece coating of a metal layer. The metal strip can have a width of ten to a few hundred millimetres or more. Moreover, the way in which the conductive layer is applied onto the metal substrate is not limited.

Figure 6 shows a diagram of an example of a continuous manufacturing process. From a stock roll 50 a steel strip 52 coated with a back electrode (not separately shown in this figure) is wound. From a stock roll 54 a photo-active layer 22 is wound and applied to the steel strip 52. Station 56 applies a sealant for forming side walls 31 (compare figure 1), if needed after the positions for the side walls have been punched into the photo-active layer. Subsequently, a transparent front electrode 34 (in this case comprising a flexible substrate 36) is applied from a stock roll 58 onto the top of upstanding sealant side walls 31, thereby establishing a gap or space 33. This gap 33 is filled with electrolyte 32 in station 60. A final sealing station 62 is provided for sealing the openings in the front electrode 34 through which the electrolyte 32 has been introduced.

Instead of using an electrode 28 coated onto the support 52, an assembly as shown in figure 5 can be applied to a steel strip 52, which optionally is provided with one or more further layers, e.g. a corrosion-resistant coating, a non-conductive coating or a combination thereof.

The assembly of layers is advantageously protected against the environment by encapsulating or sealing the solar cell which increases the lifetime of the device, and thereby further reducing ageing and corrosion of the device.

## Claims

1. A method of manufacturing a dye-sensitised solar cell (10), comprising the steps of:
providing a back electrode (28),
providing a transparent front electrode (34) for receiving light;
arranging a photo-active layer (22) comprising a matrix (24) of a non-conductive material and discrete elements (12), wherein a discrete element (12) comprises a porous structure (18) of a semi conductive material at least over part of its outer surface, in which structure a light sensitive dye is present, the discrete elements (12) being partially exposed on both main surfaces (26, 30) of the photo-active layer (22), between the transparent front electrode (34) and the back electrode (28) leaving free a gap (33) between the photo-active layer (22) and the transparent front electrode (34); and
adding an electrolyte (32) in the gap (33) between the photo-active layer (22) and the front electrode (34),
such that the discrete elements (12) of the photo-active layer (22) are in electrical contact with the back electrode (28) and with the electrolyte (32).

2. The method according to claim 1, wherein the matrix (24) of the photo-active layer comprises an insulating foil, wherein the elements (12) are embedded such that on both main surfaces (26, 30) the elements (12) are partially exposed.

3. The method according to claim 1 or 2, wherein the method is performed as a continuous process.

4. The method according to claim 3, wherein the method is a roll-to-roll process.

5. The method according to any of the preceding claims, wherein the back electrode (28) and/or the front electrode (34) are applied as layers.

6. The method according to any of the preceding claims, wherein the back electrode (28) is applied to a support (52).

7. The method according to claim 6, wherein the support (52) is a steel substrate.

8. The method according to any of the preceding claims, wherein the surface (26) of the photo-active layer (22) facing the back electrode (28) is substantially flat.

9. The method according to any of the preceding claims, wherein an element (12) comprises a core (14) supporting the porous structure (18).

10. The method according to any of the preceding claims, wherein the core (14) is made from a metal, preferably titanium.

11. The method according to any of the preceding claims 1-9, wherein the core (14) is made from an insulating material, preferably glass.

12. The method according claim 11, wherein an element (12) is provided with a diffusion barrier layer (16) between the core (14) and the porous structure (18).

13. The method according to any of the preceding claims, wherein the semi conductive material comprises titanium oxide, preferably of the anatase type.

14. A dye-sensitised solar cell (10) for conversion of light into electricity comprising:
a transparent front electrode (34) for receiving light;
a photo-active layer (22) spaced apart from the transparent front electrode (34), the photo-active layer (22) comprising a matrix (24) of a non-conductive material and discrete elements (12), wherein a discrete element (12) comprises a porous structure (18) of a semi conductive material at least over part of its outer surface, in which structure (18) a light sensitive dye is present, the discrete elements (12) being partially exposed on both main surfaces (26, 30) of the photo-active layer (22); and
an electrolyte (32) in electrical contact with the transparent front electrode (34) and the discrete elements(12) at a first main surface (30) of the photo-active layer (22); and
a back electrode (28) in electrical contact with the discrete element (12) at a second main surface (26) of the photo-active layer (22).

15. The dye-sensitised solar cell according to claim 14, wherein the matrix (24) of the photo-active layer comprises an insulating foil, wherein the elements (12) are embedded such that on both main surfaces (26, 30) the elements (12) are partially exposed.

16. The dye-sensitised solar cell according to claim 14 or claim 15, wherein the surface (26) of the photo-active layer (22) facing the back electrode (28) is substantially flat.

17. The dye-sensitised solar cell according to any of the preceding claims 14-16, wherein an element (12) comprises a core (14) supporting the outer porous structure (18).

18. The dye-sensitised solar cell according to claim 17, wherein the core (14) is made from a metal, preferably titanium.

19. The dye-sensitised solar cell according to any of the preceding claims 14-16, wherein the core (14) is made from an insulating material, preferably glass.

20. The dye-sensitised solar cell according claim 19, wherein the core (14) is provided with a diffusion barrier layer (16) between the core (14) and the outer porous structure (18).

21. The dye-sensitised solar cell according to any of the preceding claims 14-20, wherein the semi conductive material comprises titanium oxide, preferably of the anatase type.

22. The dye-sensitised solar cell according to any of the preceding claims 14-21, further comprising a support (52) for supporting the solar cell.

## Patentansprüche

1. Verfahren zum Herstellen einer Farbstoffsolarzelle (10), das die folgenden Schritte umfasst:
Vorsehen einer Rückelektrode (28),
Vorsehen einer transparenten Vorderelektrode (34) zum Aufnehmen von Licht;
Anordnen einer fotoaktiven Schicht (22), die eine Matrix (24) eines nichtleitenden Materials und diskrete Elemente (12) umfasst, wobei ein diskretes Element (12) eine poröse Struktur (18) eines halbleitenden Materials zumindest über einem Teil seiner Außenfläche umfasst, wobei in der Struktur ein lichtempfindlicher Farbstoff vorhanden ist, wobei die diskreten Elemente (12) teilweise auf beiden Flächen (26, 30) der fotoaktiven Schicht (22) zwischen der transparenten Vorderelektrode (34) und der Rückelektrode (28) freigelegt ist, was einen Spalt (33) zwischen der fotoaktiven Schicht (22) und der transparenten Vorderelektrode (34) freilässt; und
Hinzufügen eines Elektrolyten (32) zum Spalt (33) zwischen der fotoaktiven Schicht (22) und der Vorderelektrode (34),
derart dass die diskreten Elemente (12) der fotoaktiven Schicht (22) sich in elektrischem Kontakt mit der Rückelektrode (28) und mit dem Elektrolyten (32) befinden.

2. Verfahren nach Anspruch 1, wobei die Matrix (24) der fotoaktiven Schicht eine Isolierfolie umfasst, wobei die Elemente (12) derart eingebettet sind, dass auf beiden Hauptflächen (26, 30) die Elemente (12) teilweise freigelegt sind.

3. Verfahren nach Anspruch 1 oder 2, wobei das Verfahren als kontinuierlicher Prozess ausgeführt ist.

4. Verfahren nach Anspruch 3, wobei das Verfahren ein Rollenprozess ist.

5. Verfahren nach einem der vorherigen Ansprüche, wobei die Rückelektrode (28) und/oder die Vorderelektrode (34) als Schichten aufgetragen sind.

6. Verfahren nach einem der vorherigen Ansprüche, wobei die Rückelektrode (28) auf eine Unterlage (52) aufgetragen ist.

7. Verfahren nach Anspruch 6, wobei die Unterlage (52) eine Stahlunterlage ist.

8. Verfahren nach einem der vorherigen Ansprüche, wobei die Oberfläche (26) der fotoaktiven Schicht (22), die der Rückelektrode (28) zugewandt ist, im Wesentlichen eben ist.

9. Verfahren nach einem der vorherigen Ansprüche, wobei ein Element (12) einen Kern (14) umfasst, der die poröse Struktur (18) trägt.

10. Verfahren nach einem der vorherigen Ansprüche, wobei der Kern (14) aus einem Metall, vorzugsweise Titan, hergestellt ist.

11. Verfahren nach einem der vorherigen Ansprüche 1-9, wobei der Kern (14) aus einem isolierenden Material, vorzugsweise Glas, hergestellt ist.

12. Verfahren nach Anspruch 11, wobei ein Element (12) mit einer Diffusionssperrschicht (16) zwischen dem Kern (14) und der porösen Struktur (18) versehen ist.

13. Verfahren nach einem der vorherigen Ansprüche, wobei das halbleitende Material Titanoxid umfasst, vorzugsweise vom Typ Anatas.

14. Farbstoffsolarzelle (10) zur Umwandlung von Licht in elektrische Energie, umfassend:
eine transparente Vorderelektrode (34) zum Aufnehmen von Licht;
eine fotoaktive Schicht (22) mit Abstand von der transparenten Vorderelektrode (34), wobei die fotoaktive Schicht (22) eine Matrix (24) eines nichtleitenden Materials und diskrete Elemente (12) umfasst, wobei ein diskretes Element (12) eine poröse Struktur (18) eines halbleitenden Materials zumindest über einem Teil seiner Außenfläche umfasst, wobei in der Struktur (18) ein lichtempfindlicher Farbstoff vorhanden ist, wobei die diskreten Elemente (12) auf beiden Hauptflächen (26, 30) der fotoaktiven Schicht (22) teilweise freigelegt sind; und
einen Elektrolyten (32) in elektrischem Kontakt mit der transparenten Vorderelektrode (34) und den diskreten Elementen (12) an einer ersten Hauptfläche (30) der fotoaktiven Schicht (22); und
eine Rückelektrode (28) in elektrischem Kontakt mit dem diskreten Element (12) an einer zweiten Hauptfläche (26) der fotoaktiven Schicht (22).

15. Farbstoffsolarzelle nach Anspruch 14, wobei die Matrix (24) der fotoaktiven Schicht eine Isolierfolie umfasst, wobei die Elemente (12) derart eingebettet sind, dass auf beiden Hauptflächen (26, 30) die Elemente (12) teilweise freigelegt sind.

16. Farbstoffsolarzelle nach Anspruch 14 oder 15, wobei die Oberfläche (26) der fotoaktiven Schicht (22), die der Rückelektrode (28) zugewandt ist, im Wesentlichen eben ist.

17. Farbstoffsolarzelle nach einem der vorherigen Ansprüche 14-16, wobei ein Element (12) einen Kern (14) umfasst, der die äußere poröse Struktur (18) trägt.

18. Farbstoffsolarzelle nach Anspruch 17, wobei der Kern (14) aus einem Metall hergestellt ist, vorzugsweise Titan.

19. Farbstoffsolarzelle nach einem der vorherigen Ansprüche 14-16, wobei der Kern (14) aus einem isolierenden Material, vorzugsweise Glas, hergestellt ist.

20. Farbstoffsolarzelle nach Anspruch 19, wobei der Kern (14) mit einer Diffusionssperrschicht (16) zwischen dem Kern (14) und der äußeren porösen Struktur (18) versehen ist.

21. Farbstoffsolarzelle nach einem der vorherigen Ansprüche 14-20, wobei das halbleitende Material Titanoxid umfasst, vorzugsweise vom Typ Anatas.

22. Farbstoffsolarzelle nach einem der vorherigen Ansprüche 14-21, die ferner eine Unterlage (52) zum Tragen der Solarzelle umfasst.

## Revendications

1. Procédé de fabrication d'une cellule solaire à colorant (10), comprenant les étapes de :
la fourniture d'une électrode arrière (28),
la fourniture d'une électrode avant transparente (34) pour recevoir de la lumière ;
l'agencement d'une couche photo-active (22) comprenant une matrice (24) d'un matériau non conducteur et d'éléments discrets (12), dans lequel un élément discret (12) comprend une structure poreuse (18) d'un matériau semi-conducteur au moins sur une partie de sa surface extérieure, un colorant sensible à la lumière étant présent dans ladite structure, les éléments discrets (12) étant partiellement exposés sur les deux surfaces principales (26, 30) de la couche photo-active (22), entre l'électrode avant transparente (34) et l'électrode arrière (28) en laissant un espacement (33) libre entre la couche photo-active (22) et l'électrode avant transparente (34) ; et
l'ajout d'un électrolyte (32) dans l'espacement (33) entre la couche photo-active (22) et l'électrode avant (34),
de telle sorte que les éléments discrets (12) de la couche photo-active (22) soient en contact électrique avec l'électrode arrière (28) et avec l'électrolyte (32).

2. Procédé selon la revendication 1, dans lequel la matrice (24) de la couche photo-active comprend une feuille isolante, dans lequel les éléments (12) sont incorporés de manière à ce que les éléments (12) soient partiellement exposés sur les deux surfaces principales (26, 30).

3. Procédé selon la revendication 1 ou 2, dans lequel le procédé est effectué en tant que processus continu.

4. Procédé selon la revendication 3, dans lequel le procédé est un processus de rouleau à rouleau.

5. Procédé selon l'une quelconque des revendications précédentes, dans lequel l'électrode arrière (28) et/ou l'électrode avant (34) sont appliquées sous forme de couches.

6. Procédé selon l'une quelconque des revendications précédentes, dans lequel l'électrode arrière (28) est appliquée sur un support (52).

7. Procédé selon la revendication 6, dans lequel le support (52) est un substrat d'acier.

8. Procédé selon l'une quelconque des revendications précédentes, dans lequel la surface (26) de la couche photo-active (22) faisant face à l'électrode arrière (28) est sensiblement plate.

9. Procédé selon l'une quelconque des revendications précédentes, dans lequel un élément (12) comprend un coeur (14) supportant la structure poreuse (18).

10. Procédé selon l'une quelconque des revendications précédentes, dans lequel le coeur (14) est constitué d'un métal, de préférence du titane.

11. Procédé selon l'une quelconque des revendications 1 à 9, dans lequel le coeur (14) est constitué d'un matériau isolant, de préférence du verre.

12. Procédé selon la revendication 11, dans lequel un élément (12) est pourvu d'une couche de barrière de diffusion (16) entre le coeur (14) et la structure poreuse (18).

13. Procédé selon l'une quelconque des revendications précédentes, dans lequel le matériau semi-conducteur comprend de l'oxyde de titane, de préférence du type anatase.

14. Cellule solaire à colorant (10), pour la conversion de lumière en électricité, comprenant :
une électrode avant transparente (34) pour recevoir de la lumière ;
une couche photo-active (22) espacée de l'électrode avant transparente (34), la couche photo-active (22) comprenant une matrice (24) d'un matériau non conducteur et d'éléments discrets (12), dans laquelle un élément discret (12) comprend une structure poreuse (18) d'un matériau semi-conducteur au moins sur une partie de sa surface extérieure, un colorant sensible à la lumière étant présent dans ladite structure (18), les éléments discrets (12) étant partiellement exposés sur les deux surfaces principales (26, 30) de la couche photo-active (22) ; et
un électrolyte (32) en contact électrique avec l'électrode avant transparente (34) et les éléments discrets (12) à une première surface principale (30) de la couche photo-active (22) ; et
une électrode arrière (28) en contact électrique avec l'élément discret (12) à une deuxième surface principale (26) de la couche photo-active (22).

15. Cellule solaire à colorant selon la revendication 14, dans laquelle la matrice (24) de la couche photo-active comprend une feuille isolante, dans laquelle les éléments (12) sont incorporés de sorte que les éléments (12) soient partiellement exposés sur les deux surfaces principales (26, 30).

16. Cellule solaire à colorant selon la revendication 14 ou 15, dans laquelle la surface (26) de la couche photo-active (22) faisant face à l'électrode arrière (28) est sensiblement plate.

17. Cellule solaire à colorant selon l'une quelconque des revendications 14 à 16, dans laquelle un élément (12) comprend un coeur (14) supportant la structure poreuse extérieure (18).

18. Cellule solaire à colorant selon la revendication 17, dans laquelle le coeur (14) est constitué d'un métal, de préférence du titane.

19. Cellule solaire à colorant selon l'une quelconque des revendications 14 à 16, dans laquelle le coeur (14) est constitué d'un matériau isolant, de préférence du verre.

20. Cellule solaire à colorant selon la revendication 19, dans laquelle le coeur (14) est pourvu d'une couche de barrière de diffusion (16) entre le coeur (14) et la structure poreuse extérieure (18).

21. Cellule solaire à colorant selon l'une quelconque des revendications 14 à 20, dans laquelle le matériau semi-conducteur comprend de l'oxyde de titane, de préférence du type anatase.

22. Cellule solaire à colorant selon l'une quelconque des revendications 14 à 21, comprenant en outre un support (52) pour supporter la cellule solaire.
